# EUROPÄISCHE PATENTSCHRIFT

(11) **EP 1 358 364 B1**
(45) Veröffentlichungstag und Bekanntmachung des Hinweises auf die Patenterteilung: **21.07.2004**
(21) Anmeldenummer: 01989461.7
(22) Anmeldetag: 10.11.2001
(51) Int. Cl.: C23C 16/448, G05D 7/06, G05D 7/03, G05D 7/00

(54) **VERFAHREN UND VORRICHTUNG ZUR DOSIERTEN ABGABE KLEINER FLÜSSIGKEITSVOLUMENSTRÖME**
METHOD AND DEVICE FOR THE METERED DELIVERY OF LOW VOLUMETRIC FLOWS
PROCEDE ET DISPOSITIF PERMETTANT DE DELIVRER DE MANIERE DOSEE DE PETITS DEBITS VOLUMETRIQUES DE LIQUIDE

(30) Priorität: 30.11.2000 DE 10059386
(43) Veröffentlichungstag der Anmeldung: 05.11.2003
(73) Patentinhaber: Aixtron AG, 52072 Aachen (DE)
(72) Erfinder: STRAUCH, Gerd, 52072 Aachen (DE); JAKOB, Markus, 52156 Monschau (DE); LINDNER, Johannes, 52072 Aachen (DE)
(74) Vertreter: Grundmann, Dirk, Dr.
(86) Internationale Anmeldenummer: PCT/EP2001/013074
(87) Internationale Veröffentlichungsnummer: WO 2002/044441

(56) Entgegenhaltungen:
- EP-A- 0 040 540
- EP-A- 0 696 472
- EP-A- 0 939 145
- CH-A- 672 850
- US-A- 5 399 388
- US-A- 5 496 408
- DATABASE INSPEC [Online] INSTITUTE OF ELECTRICAL ENGINEERS, STEVENAGE, GB; FITCH J S ET AL: "Pressure-based mass-flow control using thermopneumatically-actuated microvalves" Database accession no. 6208608 XP002195287 & TECHNICAL DIGEST. SOLID-STATE SENSOR AND ACTUATOR WORKSHOP, TECHNICAL DIGEST SOLID-STATE SENSOR AND ACTUATOR WORKSHOP, HILTON HEAD ISLAND, SC, USA, 8-11 JUNE 1998, Seiten 162-165, 1998, Cleveland, OH, USA, Transducer Res. Found, USA ISBN: 0-9640024-2-6

## Beschreibung

Die Erfindung betrifft ein Verfahren und eine Vorrichtung zur dosierten Abgabe kleiner Flüssigkeitsvolumenströme durch Einleiten eines Gasstroms in einen eine Flüssigkeit beinhaltenden Tank und Verdrängen der Flüssigkeit durch eine Flüssigkeitsleitung.

Ein derartiges Verfahren bzw. eine Vorrichtung zur Ausübung des Verfahrens offenbart die WO99/16929. Diese Schrift beschreibt ein LDS (liquid precursor delivery system). Derartige Vorrichtungen werden verwendet, um gasförmige Komponenten einer CVD-Anlage zuzuführen. Die gasförmigen Komponenten werden dabei beispielsweise nach vorheriger Zerstäubung durch Kontakt mit einer heißen Oberfläche verdampft oder unmittelbar beispielsweise in einer Fritte durch Kontakt der Flüssigkeit mit einer heißen Oberfläche verdampft. Die dort zu dosierenden Flüssigkeitsströme haben eine Größe von oft weniger als 10 ml/min. Die direkte Messung derartig kleiner Volumenströme ist problematisch. Andererseits erfordert die Abscheidung beispielsweise ferro-elektrischer Materialien aus der Gasphase auf einer Halbleiterschicht eine reproduzierbare Einstellung und Dosierung der flüssigen metallorganischen Strontium-, Barium-, Titan-, Bismut- oder Tantal-Verbindungen.

Der Erfindung liegt daher die Aufgabe zugrunde, das gattungsgemäße Verfahren bzw. die gattungsgemäße Vorrichtung zu verbessern.

Gelöst wird die Aufgabe durch die in den Ansprüchen angegebene Erfindung. Der Anspruch 1 sieht zunächst und im Besonderen vor, dass aus einem massenflussgeregelten Gasstrom bei konstant gehaltenem Druck, welcher im Wesentlichen dem Gasdruck im Tank entspricht, ein Teilgasstrom abgezweigt wird, welcher zur Verdrängung der Flüssigkeit in den Tank geleitet wird, dessen Massenstrom gemessen wird, wobei durch Variation des Drucks ein Teilgasmassenstrom eingestellt wird, dessen unter Beiziehung der Gasdichte ermittelbarer Volumenstrom dem Sollwert des Flüssigkeitsvolumenstrom entspricht. Das Verfahren wird bevorzugt dadurch weitergebildet, dass der Teilgasstrom mindestens um einen Faktor 100 kleiner ist als der Gasstrom. Der Gasstrom wird bevorzugt auch bei Variation des Drucks konstant gehalten. In einer bevorzugten Weiterbildung ist vorgesehen, dass der Flüssigkeitsvolumenstrom insbesondere in einem gasförmigen Zustand gebracht einem CVD-Reaktor zugeleitet wird. Der Flüssigkeitsstrom kann dabei gepulst zerstäubt werden. Das dadurch entstehende Aerosol kann durch Wärmezugabe verdampft werden.

Die gattungsgemäße Vorrichtung wird erfindungsgemäß dadurch weitergebildet, dass ein Gasmassenflussregler zum Bereitstellen eines konstanten Gasstroms vorgesehen ist, von welchem bei mittels eines Druckreglers konstant gehaltenem Druck, der im Wesentlichen dem Gasdruck im Tank entspricht, ein Teilgasstrom abzweigbar ist, welcher durch einen einen geringen Strömungswiderstand aufweisenden Gasmassenflussmesser hindurch in den Tank geleitet wird, mit einem Regelorgan, mit welchem durch Variation des vom Druckregler geregelten Drucks ein durch den Gasmassenflussmesser strömender Teilgasmassenstrom einstellbar ist, so dass dessen entsprechender Volumenstrom dem Sollwert des Flüssigkeitsvolumenstroms entspricht. Die Vorrichtung kann bevorzugt einer CVD-Anlage als Quelle für ein flüssiges Reaktant zugeordnet sein. Der Flüssigkeitsstrom kann weiter einer insbesondere pulsierenden Zerstäuberdüse zugeleitet werden. Das von der Zerstäuberdüse erzeugte Aerosol kann nach Verdampfen im gasförmigen Zustand einer Prozesskammer eines CVD-Reaktors zugeleitet werden.

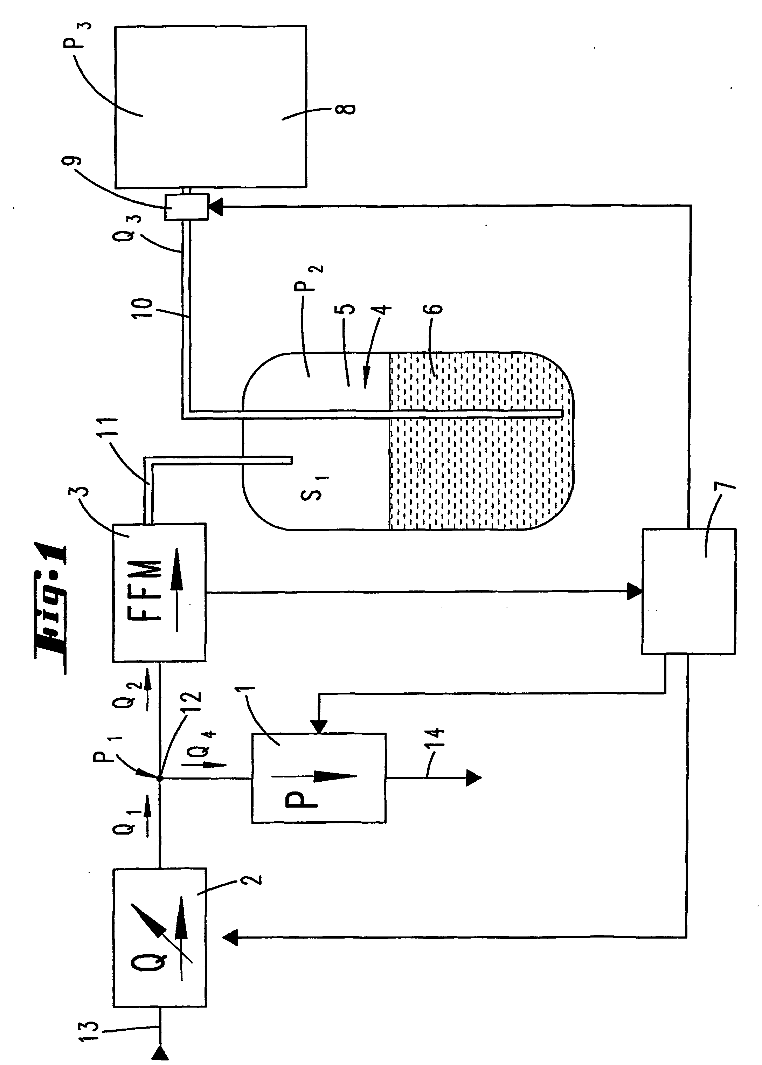

Ein Ausführungsbeispiel der Erfindung wird nachfolgend anhand beigefügter Zeichnung erläutert. Die Zeichnung zeigt schematisch den Aufbau einer Vorrichtung zur Durchführung des Verfahrens.

Aus einer Zuleitung 13 strömt ein Gasstrom, beispielsweise Wasserstoff oder Stickstoff oder ein anderes Inertgas durch einen Gasmassenflussregler 2. Der von dem Gasmassenflussregler 2 bereitgestellte Gasstromfluss Q1 strömt an einem Abzweig 12 vorbei, einem Druckregler 1 zu, welcher den Druck im Bereich der Abzweigung 12 konstant auf einem Druck P1 hält. Das überschüssige Gas fließt aus einer Ableitung aus dem Druckregler 1 heraus.

Am Abzweig 12 wird ein vergleichsweise kleiner Teilgasstrom Q2 abgezweigt. Der Teilgasstrom Q2 ist etwa hundert Mal kleiner, als der Gasstrom Q1, der im Wesentlichen durch die Ableitung 14 als Gasfluss Q4 fließt.

Der Teilgasstrom Q2 durchströmt einen Gasmassenflussmesser 3. Der Strömungswiderstand des Gasmassenflussreglers ist vergleichsweise gering. Dies hat zur Folge, dass in der Gasleitung 11, die aus dem Gasmassenflussmesser 3 herausführt und in einen Tank 5 hineinführt, im Wesentlichen der gleiche Druck P2 herrscht, der auch vom Druckregler 1 am Abzweig 12 konstant gehalten wird.

Durch den Druckregler 1 lässt sich daher der Druck P2 des Gases 5 im Tank 4 konstant halten.

In dem Tank 4 befindet sich eine Flüssigkeit 6. In die Flüssigkeit 6 ragt ein Steigrohr 10, welches zu einer außerhalb des Tanks liegenden Zerstäuberdüse 9 führt. Die Zerstäuberdüse 9 kann gepulst sein und bildet ein Aerosol. Das aus der Zerstäuberdüse 9 austretende Aerosol wird in der Reaktionskammer 8 bei einem Druck P3 durch Zugabe von Wärme verdampft. Die Flüssigkeit kann eine metallorganische Verbindung sein. Die Prozesskammer dient bevorzugt zum Abscheiden ferroelektrischer Schichten auf Halbleiteroberflächen.

Die Vorrichtung besitzt ferner ein Regelorgan 7, welches den Messwert des Gasmassenflussmessers 3 als eine Eingangsgröße verwendet. Unter Berücksichtigung der Gasdichte des Gases 5 im Tank 4 kann aus dem gemessenen Massenfluss ein Volumenstrom ermittelt werden. Das Regelorgan 7 regelt diesen Volumenstrom Q2 auf eine Größe, die dem Sollwert des Flüssigkeitsvolumenstroms Q3 entspricht. Hierzu wird der Druck P1 durch Variation des dem Druckregler 1 gegebenen Sollwert derart eingestellt, dass der durch den Gasmassenflussmesser 3 hindurchfließende Volumen-Gasstrom dem Sollwert des Flüssigkeitsvolumenstrom Q3 entspricht. Der im Wesentlichen konstant gehaltene Massenfluss Q1, welcher vom Gasmassenflussregler 2 bereitgestellt wird. kann ebenfalls vom Regelorgan beeinflusst werden. Das Regelorgan 7 kann ebenso eine Zerstäuberdüse 9 ansteuern. Die Zerstäuberdüse 9 kann dabei kontinuierlich oder pulsweise betrieben werden.

Das Verfahren beruht im Wesentlichen auf der Erkenntnis, dass der Volumenstrom Q2 abhängig von den geometrischen Verhältnissen der Gasleitung 11 und dem Gasmassenflussmesser 3 bei gleichgehaltener Temperatur eine nahezu eindeutige Beziehung zwischen gemessenem Massenfluss des Teilgasstromes Q2 und dessen Volumenstrom gibt.

Wenn der Flüssigkeitsvolumenstrom Q3 variiert werden soll, so variiert das Regelorgan 7 den Vorgabewert für den Druckregler 1 so lange, bis am Gasmassenflussmesser 3 ein Gasmassenfluss gemessen wird, der unter Beiziehung der Dichte des Gases 5 beim Druck P2 dem Volumenstrom Q3 entspricht.

## Patentansprüche

1. Verfahren zur dosierten Abgabe kleiner Flüssigkeitsvolumenströme durch Einleiten eines Gasstromes in einen eine Flüssigkeit beinhaltenden Tank und Verdrängung der Flüssigkeit durch eine Flüssigkeitsleitung, **dadurch gekennzeichnet, dass** aus einem massenflussgeregelten Gasstrom (Q1) bei konstant gehaltenem Druck (P1), welcher im Wesentlichen dem Gasdruck (P2) im Tank (4) entspricht, ein Teilgasstrom (Q2) abgezweigt wird, welcher zur Verdrängung der Flüssigkeit in den Tank geleitet wird, wobei der Massenstrom des Teilgasstromes (2) gemessen wird, wobei durch Variation des Druckes (P1) ein Teilgasmassenstrom eingestellt wird, dessen unter Beiziehung der Gasdichte (Q1) ermittelbarer Volumenstrom dem Sollwert des Flüssigkeitsvolumenstroms (Q3) entspricht.

2. Verfahren nach Anspruch 1 oder insbesondere danach, **dadurch gekennzeichnet, dass** der Teilgasstrom (Q2) mindestens um einen Faktor 100 kleiner ist als der Gastrom (Q1).

3. Verfahren nach einem oder mehreren der vorhergehenden Ansprüche oder insbesondere danach, **dadurch gekennzeichnet, dass** der Gastrom (Q1) bei Variation des Drukkes (P1) im Wesentlichen konstant gehalten wird.

4. Verfahren nach einem oder mehreren der vorhergehenden Ansprüche oder insbesondere danach, **dadurch gekennzeichnet, dass** der Flüssigkeitsvolumenstrom insbesondere in einen gasförmigen Zustand gebracht einen CVD-Reaktor (8) zugeleitet wird.

5. Verfahren nach einem oder mehreren der vorhergehenden Ansprüche oder insbesondere danach, **dadurch gekennzeichnet, dass** der Flüssigkeitsvolumenstrom (Q3) insbesondere gepulst zerstäubt wird und das dadurch entstandene Aerosol durch Wärmezugabe verdampft wird.

6. Vorrichtung zur dosierten Abgabe kleiner Flüssigkeitsvolumenströme durch Einleiten eines Gasstromes in einen eine Flüssigkeit beinhaltenden Tank und Verdrängen der Flüssigkeit durch eine Flüssigkeitsleitung, **gekennzeichnet durch** einen Gasmassenflussregler (2) zum Bereitstellen eines konstanten Gasstroms (Q1), von welchem bei mittels eines Druckkreglers (1) konstant gehaltenen Druck (P1), der im Wesentlichen dem Gasdruck (P2) im Tank (4) entspricht, ein Teilgasstrom (Q2) abzeigbar ist, welcher **durch** einen, einen geringen Strömungswiderstand aufweisenden Gasmassenflussmesser (3) hindurch in den Tank (4) geleitet wird, mit einem Regelorgan (7), mit welchem **durch** Variation des vom Druckregler (1) geregelten Drucks (P1) ein **durch** den Gasmassenflussmesser (3) strömender Teilgasmassenstrom einstellbar ist, so dass dessen entsprechender Volumenstrom dem Sollwert des Flüssigkeitsvolumenstroms (Q3) entspricht.

7. Vorrichtung zur dosierten Abgabe kleiner Flüssigkeitsvolumenstrome nach Anspruch 6, **dadurch gekennzeichnet, dass** die Vorrichtung einer CVD-Anlage als Quelle für ein flüssiges Reaktant zugeordnet ist.

8. Vorrichtung zur dosierten Abgabe kleiner Flüssigkeitsvolumenströme nach Anspruch 6, **dadurch gekennzeichnet, dass** der Flüssigkeitsstrom einer insbesondere pulsierenden Zerstäuberdüse (9) zugeleitet wird.

9. Vorrichtung zur dosierten Abgabe kleiner Flüssigkeitsvolumenströme nach Anspruch 6, **dadurch gekennzeichnet, dass** das von der Zerstäuberdüse (9) abgegebene Aerosol durch Wärmezugabe verdampft, der Prozesskmmer eines CVD-Reaktors zugeleitet wird.

## Claims

1. Method for the metered delivery of low volumetric flows of liquid by introduction of a gas flow into a tank containing a liquid and displacement of the liquid through a liquid line, **characterized in that** a partial gas flow (Q2), which is conducted into the tank in order to displace the liquid, is branched off from a mass-flow-controlled gas flow (Q1) at a pressure (P1) which is kept constant and substantially corresponds to the gas pressure (P2) in the tank (4), the mass flow of the partial gas flow (2) being measured, a partial gas mass flow, the volumetric flow of which can be determined with reference to the gas density (Q1) and corresponds to the desired value of the liquid volumetric flow (Q3), being set by varying the pressure (P1).

2. Method according to Claim 1 or in particular according thereto, **characterized in that** the partial gas flow (Q2) is smaller than the gas flow (Q1) by at least a factor of 100.

3. Method according to one or more of the preceding claims or in particular according thereto, **characterized in that** the gas flow (Q1) is kept substantially constant in the event of the pressure (P1) varying.

4. Method according to one or more of the preceding claims or in particular according thereto, **characterized in that** the liquid volumetric flow, having in particular been brought to a gaseous state, is fed to a CVD reactor (8).

5. Method according to one or more of the preceding claims or in particular according thereto, **characterized in that** the liquid volumetric flow (Q3) is atomized, in particular in pulsed fashion, and the aerosol which results is evaporated by the addition of heat.

6. Device for the metered delivery of low volumetric flows of liquid by introduction of a gas flow into a tank containing a liquid and displacement of the liquid through a liquid line, **characterized by** a gas mass flow controller (2) for providing a constant gas flow (Q1), from which a partial gas flow (Q2), which is conducted into the tank (4) through a gas mass flowmeter (3) which has a low flow resistance, can be branched off at a pressure (P1) which is kept constant by means of a pressure controller (1) and substantially corresponds to the gas pressure (P2) in the tank (4), having a control element (7), by means of which a partial gas mass flow flowing through the gas mass flowmeter (3) can be set by varying the pressure (P1) controlled by the pressure controller (1), so that the corresponding volumetric flow of this partial gas mass flow corresponds to the desired value for the liquid volumetric flow (Q3).

7. Device for the metered delivery of low volumetric flows of liquid according to Claim 6, **characterized in that** the device is associated with a CVD installation as source of a liquid reactant.

8. Device for the metered delivery of low volumetric flows of liquid according to Claim 6, **characterized in that** the liquid flow is fed to an, in particular pulsating, atomizer nozzle (9).

9. Device for the metered delivery of low volumetric flows of liquid according to Claim 6, **characterized in that** the aerosol released by the atomizer nozzle (9) is evaporated by the addition of heat and fed to the process chamber of a CVD reactor.

## Revendications

1. Procédé permettant de délivrer de façon dosée de petits débits volumétriques de liquide en introduisant un flux de gaz dans un réservoir contenant un liquide et en évacuant le liquide par une conduite de liquide, **caractérisé en ce que** l'on dérive, à une pression constante (P1) correspondant sensiblement à la pression (P2) du gaz dans le réservoir (4), à partir d'un flux de gaz (Q1) à débit massique régulé un flux de gaz partiel (Q2) qui est introduit dans le réservoir dans le but d'évacuer le liquide, le débit massique du flux de gaz partiel (2) étant mesuré, un débit massique partiel de gaz étant régulé en faisant varier la pression (P1), dont le débit volumétrique, pouvant être déterminé en ayant recours à la densité (Q1) du gaz, correspond à la valeur de consigne du débit volumétrique (Q3) du liquide.

2. Procédé selon la revendication 1 ou procédé en particulier selon la revendication 1, **caractérisé en ce que** le flux de gaz partiel (Q2) est inférieur au flux de gaz (Q1) d'au moins un facteur 100.

3. Procédé selon l'une ou plusieurs des revendications précédentes ou procédé en particulier selon l'une ou plusieurs des revendications précédentes, **caractérisé en ce que** le flux de gaz (Q1) est maintenu sensiblement constant lorsque l'on fait varier la pression (P1).

4. Procédé selon l'une ou plusieurs des revendications précédentes ou procédé en particulier selon l'une ou plusieurs des revendications précédentes, **caractérisé en ce que** le débit volumétrique du liquide est canalisé, en particulier amené à un état gazeux, à un réacteur CVD (8).

5. Procédé selon l'une ou plusieurs des revendications précédentes ou procédé en particulier selon l'une ou plusieurs des revendications précédentes, **caractérisé en ce que** le débit volumique (Q3) du liquide est atomisé en particulier en mode pulsé et l'aérosol ainsi généré est vaporisé par apport de chaleur.

6. Dispositif permettant de délivrer de façon dosée de petits débits volumétriques de liquide en introduisant un flux de gaz dans un réservoir contenant un liquide et en évacuant le liquide par une conduite de liquide, **caractérisé par** un régulateur de débit massique de gaz (2) permettant de générer un flux de gaz constant (Q1) à partir duquel un flux de gaz partiel (Q2) peut être dérivé à une pression (P1) qui est maintenue constante au moyen d'un régulateur de pression (1) et qui correspond sensiblement à la pression (P2) du gaz dans le réservoir (4), le flux de gaz partiel (Q2) étant introduit, via un dispositif de mesure de débit massique de gaz (3) présentant une faible résistance à l'écoulement, dans le réservoir (4) doté d'un organe de régulation (7) permettant de régler un débit massique de gaz partiel s'écoulant à travers le dispositif de mesure de débit massique de gaz (3) en faisant varier la pression (P1) régulée par le régulateur de pression (1) de sorte que le débit volumétrique correspondant du gaz correspond à la valeur de consigne du débit volumétrique (Q3) du liquide.

7. Dispositif permettant de délivrer de façon dosée de petits débits volumétriques de liquide selon la revendication 6, **caractérisé en ce que** le dispositif est associé à une installation CVD, servant de source de réactif liquide.

8. Dispositif permettant de délivrer de façon dosée de petits débits volumétriques de liquide selon la revendication 6, **caractérisé en ce que** le flux de liquide est amené à une buse d'atomisation (9) fonctionnant en particulier en mode pulsé.

9. Dispositif permettant de délivrer de façon dosée de petits débits volumétriques de liquide selon la revendication 6, **caractérisé en ce que** l'aérosol délivré par la buse d'atomisation (9) est vaporisé par apport de chaleur et est amené à la chambre d'un réacteur CVD.
